# EUROPEAN PATENT SPECIFICATION

(11) **EP 1 568 499 B1**
(45) Date of publication and mention of the grant of the patent: **09.07.2008**
(21) Application number: 05251103.7
(22) Date of filing: 24.02.2005
(51) Int. Cl.: B41J 2/14, B41J 2/16

(54) **Piezoelectric inkjet printhead and method of manufacturing nozzle plate**
Piezoelektrischer Tintenstrahldruckkopf und Verfahren zur Herstellung einer Düsenplatte
Tête d'impression à jet d'encre et méthode de fabrication de la plaque à orifices

(30) Priority: 27.02.2004 KR 2004013567
(43) Date of publication of application: 31.08.2005
(60) Divisional application: 07101257.9
(73) Proprietor: SAMSUNG ELECTRONICS CO., LTD., Suwon-si, Gyeonggi-do (KR)
(72) Inventor: Lee, Jae-chang, Hwaseong-si, Gyeonggi-do (KR); Oh, Jung-min, Yongin-si, Gyeonggi-do (KR); Chung, Jae-woo, Yeongtong-gu, Suwon-si, Gyeonggi-do (KR); Kim, Jong-beom, Yongin-si, Gyeonggi-do (KR); Lim, Seung-mo, Yongin-si, Gyeonggi-do (KR)
(74) Representative: Anderson, James Edward George

(56) References cited:
- EP-A- 0 321 075
- EP-A- 0 609 011
- EP-A- 0 900 657
- EP-A- 1 413 438
- US-A1- 2002 001 015
- US-A1- 2003 081 064
- PATENT ABSTRACTS OF JAPAN vol. 014, no. 147 (M-0952), 20 March 1990 (1990-03-20) & JP 02 011331 A (FUJI XEROX CO LTD), 16 January 1990 (1990-01-16)
- PATENT ABSTRACTS OF JAPAN vol. 017, no. 186 (M-1395), 12 April 1993 (1993-04-12) & JP 04 338546 A (FUJITSU LTD), 25 November 1992 (1992-11-25)

## Description

The present invention relates to a piezoelectric inkjet printhead, and more particularly, to a piezoelectric inkjet printhead including a nozzle plate integrally formed with a heater for heating ink and a method of manufacturing the nozzle plate.

Generally, an inkjet printhead is a device that ejects ink droplets at a desired position on a recording medium thereby printing a desired color image. According to an ink ejection method, the inkjet printhead can be classified into a thermal inkjet printhead and a piezoelectric inkjet printhead. With respect to the thermal inkjet printhead, ink is heated to form ink bubbles and the expansive force of the bubbles causes ink droplets to be ejected. With respect to the piezoelectric inkjet printhead, the deformation of a piezoelectric crystal pushes ink droplets onto a recording medium.

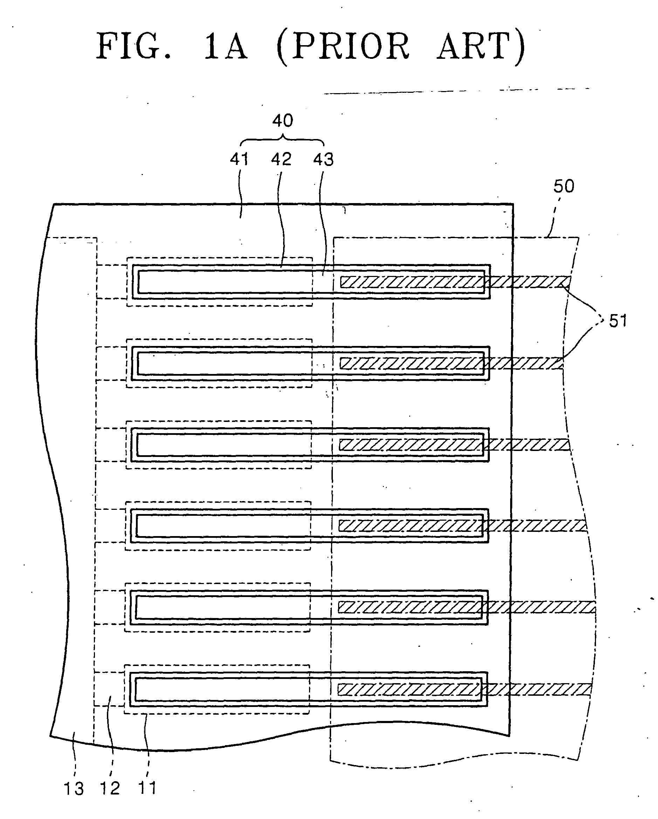

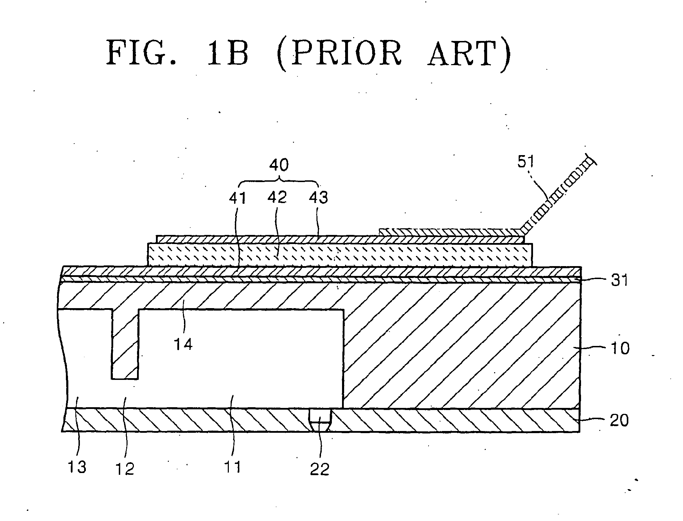

FIG. 1A is a plan view that illustrates a common construction of a conventional piezoelectric inkjet printhead and FIG. 1B is a vertical sectional view taken along the longitudinal direction of a piezoelectric layer.

Referring to FIGS. 1A and 1B, a flow path plate 10 is formed with ink flow paths including a manifold 13, a plurality of restrictors 12, and a plurality of pressure chambers 11. A nozzle plate 20 is formed with a plurality of nozzles 22 corresponding to the respective pressure chambers 11. A piezoelectric actuator 40 is disposed at an upper side of the flow path plate 10. The manifold 13 is a common passage through which ink from an ink reservoir (not shown) is introduced into the pressure chambers 11. The restrictors 12 are individual passages through which ink from the manifold 13 is introduced into the respective pressure chambers 11. The pressure chambers 11 are filled with ink to be ejected and are disposed at one or both sides of the manifold 13. The volumes of the pressure chambers 11 are changed according to the driving of the piezoelectric actuator 40, thereby generating a change of pressure for ink ejection or introduction. For this, upper walls of the pressure chambers 11 of the flow path plate 10 serve as vibrating plates 14 that can be deformed by the piezoelectric actuator 40.

The piezoelectric actuator 40 includes a lower electrode 41, piezoelectric layers 42, and upper electrodes 43 which are sequentially stacked on the flow path plate 10. A silicon oxide layer 31 is formed as an insulating film between the lower electrode 41 and the flow path plate 10. The lower electrode 41 is formed on the entire surface of the silicon oxide layer 31 and serves as a common electrode. The piezoelectric layers 42 are formed on the lower electrode 41 so that they are positioned at upper sides of the pressure chambers 11. The upper electrodes 43 are formed on the piezoelectric layers 42 and serve as driving electrodes applying a voltage to the piezoelectric layers 42.

To apply a driving voltage to the piezoelectric actuator 40 of the above-described structure, a flexible printed circuit (FPC) 50 for voltage application is connected to the upper electrodes 43. In detail, driving signal lines 51 of the flexible printed circuit 50 are disposed on the upper electrodes 43 and then heated and pressurized, to thereby bond the driving signal lines 51 to upper surfaces of the upper electrodes 43.

However, in the case of using the above-described common inkjet printhead for ejecting high viscosity ink, flow resistance increases due to the high ink viscosity, thereby decreasing the ejection volume and ejection speed of ink droplets. Therefore, the overall ink ejection performance is lowered, which renders printing quality unsatisfactory. In this respect, to ensure a satisfactory ejection performance for high viscosity ink, reduction of ink viscosity by heating the ink with a heater is required.

For an example, U.S. Patent No. 5,701,148 discloses an ink cartridge in which a heater for heating ink is mounted outside an inkjet printhead. In the ink cartridge disclosed in this patent, however, since the heater is located relatively away from a nozzle plate, a temperature profile according to the location of the nozzle plate heated by the heater is not uniform. Therefore, ink temperature of nozzles arranged in the nozzle plate is also non-uniform, thereby causing a variation of the ejection speed and volume of ink droplets through the nozzles. Furthermore, the heater separately mounted outside the inkjet printhead increases the complexity and size of the ink cartridge.

In the case of heating ink using a heater as described above, ink temperature detection for controlling an ink temperature is required. U.S. Patent No. 6,074,033 discloses a technique of controlling printing quality by detecting an ambient temperature using a thermistor and estimating physical properties of ink from the detection result. However, this technique has a disadvantage in that an ink temperature value estimated from a detected ambient temperature may vary according to the operating condition of a printhead.

JP 02 011331 discloses a piezoelectric inkjet printhead in which a heater is formed in the nozzle plate. The heater is used for controlling the separation timing of ink droplets.

US 2002/0001015 A1 discloses a piezoelectric inkjet printhead having a heater and a temperature sensor formed on a flow path plate. The heater and temperature sensor are used for keeping the ink at a constant temperature.

According to an aspect of the present invention, there is provided a piezoelectric inkjet printhead for ejecting ink droplets onto a recording medium provided below the printhead, the printhead comprising: a flow path plate formed with an ink flow path comprising a plurality of pressure chambers filled with ink to be ejected; a piezoelectric actuator formed at an upper side of the flow path plate for supplying a driving force for ink ejection to the pressure chambers; a nozzle plate bonded to the flow path plate, a plurality of nozzles for ink ejection from the pressure chambers being bored through the nozzle plate; and a heater formed on a lower surface of the nozzle plate for heating ink in the ink flow path, wherein the printhead is characterized in that it further comprises nozzle metal layers formed around orifices of the nozzles on a lower surface of the nozzle plate, wherein the heater, the temperature detector and the nozzle metal layers are formed on the same plane and made of the same metal material.

An insulating layer may be formed on a lower surface of the nozzle plate, the heater may be formed in a predetermined pattern on a surface of the insulating layer, and a protection layer for protecting the heater may be formed on surfaces of the insulating layer and the heater.

Bonding pads for bonding a power supply line may be formed at both ends of the heater and may be exposed through contact holes formed in the protection layer.

The piezoelectric inkjet printhead may further include a temperature detector for detecting a temperature of the ink in the ink flow path. The temperature detector may be made of a metal material having a variable resistance with respect to temperature.

The temperature detector may be formed on a lower surface of the nozzle plate together with the heater and the nozzle metal layers. In this case, the heater, the nozzle metal layers and the temperature detector may be made of the same materials, for example Pt. Bonding pads for bonding a temperature detection signal line may be formed at both ends of the temperature detector.

The temperature detector may be formed at an upper side of the flow path plate together with the piezoelectric actuator. In this case, the temperature detector may be formed on the same plane using the same metal material, for example Pt, as a lower electrode of the piezoelectric actuator. The temperature detector may be defined by a trench bored through the lower electrode and be insulated from the lower electrode by the trench. A connection electrode for connecting the temperature detection signal line to the temperature detector and a dummy piezoelectric layer for supporting the connection electrode may be formed on the lower electrode.

The heater and the nozzle metal layers may be formed of Pt. Hydrophobic plating layers made of Au may be formed on surfaces of the nozzle metal layers.

According to another aspect of the present invention, there is provided a method of manufacturing a nozzle plate of a piezoelectric inkjet printhead, the printhead having a plurality of nozzles bored through the nozzle plate for ejecting ink droplets onto a recording medium provided below the printhead, the method comprising: (a) preparing a silicon substrate; (b) forming ink guiding portions of the nozzles by partially etching an upper surface of the silicon substrate; (c) coating a photoresist on a lower surface of the silicon substrate followed by patterning; (d) forming a metal layer on a lower surface of the silicon substrate and a surface of the photoresist; (e) lifting off the photoresist and removing the metal layer formed on the surface of the photoresist to form a heater for heating ink and nozzle metal layers for surrounding orifices of the nozzles from a residual portion of the metal layer; (f) forming a protection layer for protecting the heater and the nozzle metal layers on a lower surface of the silicon substrate; and (g) forming openings by partially etching the protection layer and forming ink outlets communicating with the ink guiding portions by etching portions of the silicon substrate exposed through the openings.

The method may further include forming silicon oxide layers as insulating layers on lower and upper surfaces of the silicon substrate before step (b).

In step (e), the residual metal layer may form a temperature detector for detecting ink temperature, in addition to the heater and the nozzle metal layers.

In step (g), the nozzle metal layers may be exposed through the openings and are used as etching masks for etching the silicon substrate.

The method may further include forming hydrophobic plating layers on surfaces of the nozzle metal layers, after step (g). The hydrophobic plating layers may be formed by electroplating using the nozzle metal layers as seed layers.

The method may further include forming contact holes intended for exposure of bonding pads formed at both ends of the heater by partially etching the protection layer after step (g).

According to the present invention, since a printhead has an integrally formed structure of a heater for heating ink and a nozzle plate, it can be manufactured easily and ink therein can be heated to a uniform temperature.

The present invention thus provides a simple piezoelectric inkjet printhead including a nozzle plate integrally formed with a heater for heating ink. Therefore, ink can be heated to a uniform temperature. The present invention also provides a method of manufacturing the nozzle plate.

The above and other features and advantages of the present invention will become more apparent by describing in detail exemplary embodiments thereof with reference to the attached drawings in which:
FIG. 1A is a plan view that illustrates a common construction of a conventional piezoelectric inkjet printhead and FIG. 1B is a vertical sectional view taken along the longitudinal direction of a piezoelectric layer;
FIG. 2 is a top plan view of a piezoelectric inkjet printhead according to a first embodiment of the present invention;
FIG. 3 is a bottom plan view of a nozzle plate of the inkjet printhead of FIG. 2;
FIG. 4 is a vertical sectional view taken along line A-A' of FIG. 3;
FIG. 5 is a top plan view of a piezoelectric inkjet printhead according to a second embodiment of the present invention;
FIG. 6 is a partial vertical sectional view taken along line B-B' of FIG. 5; and
FIGS. 7A through 7N are sequential sectional views that illustrate a method of manufacturing the nozzle plate of the piezoelectric inkjet printhead according to the first embodiment shown in FIGS. 3 and 4.

Hereinafter, exemplary embodiments of the present invention will be described in detail with reference to the accompanying drawings. The same reference numerals refer to the same constitutional elements throughout the drawings. In the accompanying drawings, sizes of constitutional elements have been exaggerated for clarity and convenience of illustration. Further, it will be understood that when a layer is referred to as being "on" another layer or substrate, it may be directly on the other layer or substrate, or intervening layers may also be present.

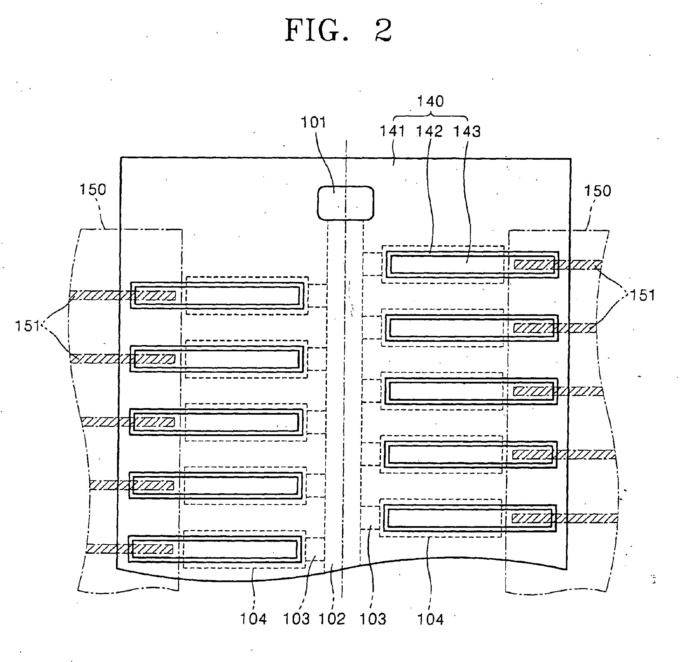

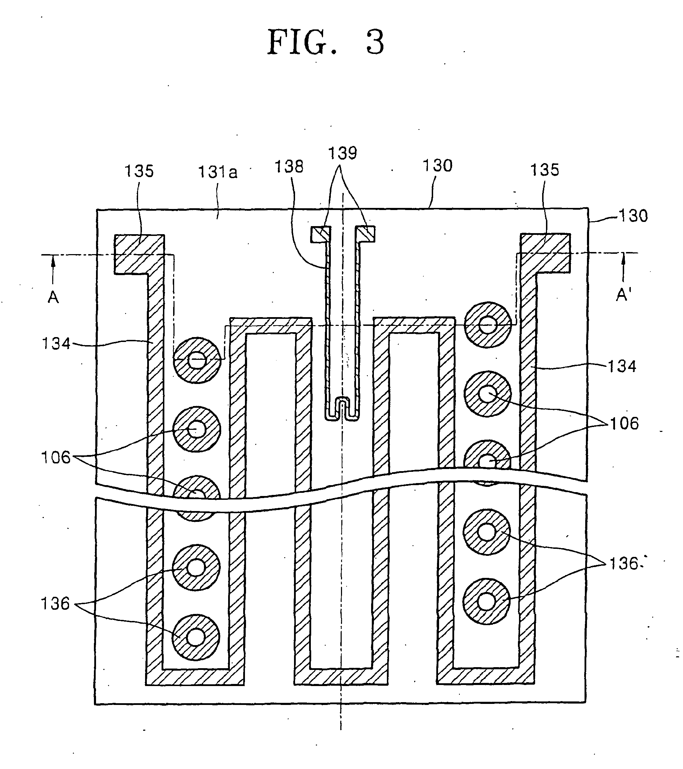

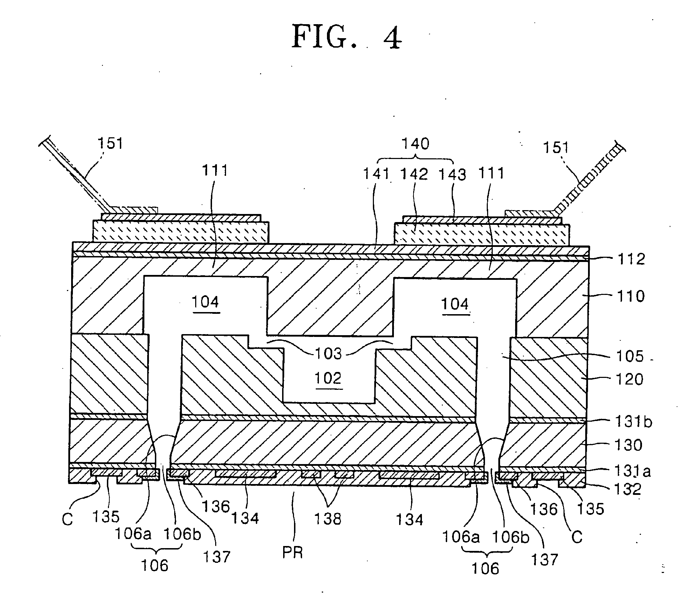

FIG. 2 is a top plan view of a piezoelectric inkjet printhead according to a first embodiment of the present invention, FIG. 3 is a bottom plan view of a nozzle plate of the inkjet printhead of FIG. 2, and FIG. 4 is a vertical sectional view taken along line A-A' of FIG. 3.

Referring to FIGS. 2 through 4, the piezoelectric inkjet printhead according to the first embodiment of the present invention includes: a flow path plate formed with an ink flow path including pressure chambers 104; a nozzle plate through 130 which nozzles 106 for ink ejection are bored; a piezoelectric actuator 140, disposed on the flow path plate, supplying a driving force for ink ejection to the pressure chambers 104; and a heater 134 for heating ink, integrally formed on a lower surface of the nozzle plate 130.

The ink flow path includes the pressure chambers 104 filled with ink to be ejected and generating a change of pressure for ink ejection, an ink inlet 101 for ink introduction from an ink reservoir (not shown), a manifold 102 which is a common flow path for ink introduction from the ink inlet 110 into the pressure chambers 104, and restrictors 103 which are individual flow paths for ink introduction from the manifold 102 into the respective pressure chambers 104. Further, dampers 105 may be provided between the pressure chambers 104 and the nozzles 106 formed in the nozzle plate 130, to concentrate energy generated in the pressure chambers 104 by the piezoelectric actuator 140 toward the nozzles 106 and to prevent a rapid pressure change. These constitutional elements for the ink flow path are formed in the flow path plate. Vibrating plates 111 that can be deformed as the piezoelectric actuator 140 is driven are disposed at upper sides of the pressure chambers 104.

In detail, the flow path plate may include a first flow path plate 110 and a second flow path plate 120 as shown in FIG. 4. In this case, the pressure chambers 104 are formed to a predetermined depth from a lower surface of the first flow path plate 110 and the ink inlet 101 is bored through one side of the first flow path plate 110. The pressure chambers 104 have a cuboidal shape which is longer along an ink flow direction and are arranged in two arrays at both sides of the manifold 102 formed in the second flow path plate 120. However, the pressure chambers 104 may also be arranged in one array at one side of the manifold 102.

As described above, the second flow path plate 120 is formed with the manifold 102. An end of the manifold 102 is connected to the ink inlet 101. The manifold 102 may be formed to a predetermined depth from an upper surface of the second flow path plate 120, as shown in FIG. 4. Alternatively, the manifold 102 may be vertically bored through the second flow path plate 120. The second flow path plate 120 is also formed with the restrictors 103 which are individual flow paths connecting the manifold 102 and respective one ends of the pressure chambers 104. Like the manifold 102, the restrictors 103 may be formed to a predetermined depth from an upper surface of the second flow path plate 120, as shown in FIG. 4, or may be vertically bored through the second flow path plate 120. The dampers 105 connecting the pressure chambers 104 and the nozzles 106 are bored through the second flow path plate 120 corresponding to the other ends of the pressure chambers 104.

Even though in the present description, the constitutional elements for the ink flow path are arranged in the two flow path plates 110 and 120, this arrangement has been provided only for illustration purposes. That is, the constitutional elements for the ink flow path can have different arrangements in a piezoelectric inkjet printhead of the present invention. These constitutional elements for the ink flow path may also be arranged in only one plate or in three or more plates, instead of the two flow path plates 110 and 120.

The piezoelectric actuator 140 is formed at an upper side of the first flow path plate 110 with the pressure chambers 104 to supply a driving force for ink ejection to the pressure chambers 104. The piezoelectric actuator 140 includes a lower electrode 141 used as a common electrode, piezoelectric layers 142 that are deformed by an applied voltage, and upper electrodes 143 used as driving electrodes. The piezoelectric actuator 140 has a sequentially stacked structure of the lower electrode 141, the piezoelectric layers 142, and the upper electrodes 143 on the first flow path plate110.

In detail, an insulating layer 112 is formed between the lower electrode 141 and the first flow path plate 110. The lower electrode 141 is formed on the entire surface of the insulating layer 112 and may be a single conductive metal material layer. However, it is preferable to form a thin metal bilayer composed of a Ti layer and a Pt layer as the lower electrode 141. The lower electrode 141 made of Ti/Pt serves as a common electrode, and at the same time, as a diffusion barrier layer for prevention of inter-diffusion between the underlying first flow path plate 110 and the overlying piezoelectric layers 142. The piezoelectric layers 142 are disposed on the lower electrode 141 corresponding to the pressure chambers 104. The piezoelectric layers 104 are deformed by an applied voltage, thereby causing bending of the vibrating plates 111 at upper sides of the pressure chambers 104. The piezoelectric layers 142 may be made of a piezoelectric material, preferably a PZT (Lead Zirconate Titanate) ceramic material. The upper electrodes 143 serve as driving electrodes applying a voltage to the piezoelectric layers 142 and are formed on the piezoelectric layers 142.

To apply a driving voltage to the piezoelectric actuator 140 of the above-described structure, a driving circuit for voltage application, for example, a flexible printed circuit (FPC) 150 is connected to the upper electrodes 143. In detail, when driving signal lines 151 of the flexible printed circuit 150 disposed on the upper electrodes 143 are heated and pressurized, the driving signal lines 151 are bonded to upper surfaces of the upper electrodes 143.

The nozzle plate 130 is bonded to a lower surface of the second flow path plate 120. The bonding between the nozzle plate 130 and the second flow path plate 120 can be performed by a Silicon Direct Bonding (SDB) method well known in the pertinent art. The nozzles 106 are bored through the nozzle plate 130 correspondingly to the dampers 105. The nozzles 106 are composed of ink outlets 106b for ink ejection formed at a lower side of the nozzle plate 130; and ink guiding portions 106a, formed at an upper side of the nozzle plate 130, connecting the dampers 105 and the ink outlets 106b and guiding ink from the dampers 105 toward the ink outlets 106b. The ink outlets 106b may be formed as vertical holes of a predetermined diameter. The ink guiding portions 106a may be formed in a square pyramidal shape having a decreasing sectional area from the dampers 105 to the ink outlets 106b. First silicon oxide layers 131a and 131b are respectively disposed on lower and upper surfaces of the nozzle plate 130 through which the nozzles 106 are bored.

The nozzle plate 130 is integrally formed with the heater 134 for heating ink. In detail, the heater 134 is formed on a surface of the first silicon oxide layer 131a covering a lower surface of the nozzle plate 130. The first silicon oxide layer 131 a serves as an insulating film for insulating the nozzle plate 130 and the heater 134. The heater 134 may be made of a resistive heating metal material, for example Pt. It is particularly preferable that the heater 134 is made of Pt since a temperature detector 138 as will be described later can be made of the same material as the heater 134.

The heater 134 may be formed in a pattern shown in FIG. 3 so that it is uniformly arranged over the entire lower surface of the first silicon oxide layer 131a. However, the heater 134 may also be formed in any pattern that can uniformly heat the entire surface of the nozzle plate 130, instead of the pattern shown in FIG. 3. Bonding pads 135 are disposed at both ends of the heater 134 to bond a power supply line (not shown) for power supply to the heater 134.

As described above, according to the present invention, the nozzle plate 130 is integrally formed with the heater 134 for heating ink, which makes it possible to simplify the construction of an inkjet printhead and decrease a manufacturing cost, relative to a conventional technique. Furthermore, since the heater 134 is uniformly arranged throughout the lower surface of the nozzle plate 130, ink inside the printhead, i.e., inside the ink flow path can be heated more uniformly. Therefore, ejection speed and volume of ink droplets through the nozzles 106 can be maintained uniform, thereby enhancing printing quality.

The nozzle plate 130 may be formed with the temperature detector 138 to detect the temperature of ink inside the ink flow path. In detail, the temperature detector 138 is formed on a surface of the first silicon oxide layer 131a of a lower surface of the nozzle plate 130, together with the heater 134. The temperature detector 138 is made of a metal that has an electrical resistance varying with temperature. This metal may be any metal known in the art. However, as describe above, it is preferable to use Pt since both the temperature detector 138 and the heater 134 can be made of Pt.

The temperature detector 138 is formed on a surface portion of the first silicon oxide layer 131a in such a way to be insulated from the heater 134, as shown in FIG. 3. Bonding pads 139 are disposed at both ends of the temperature detector 134 to bond a temperature detection signal line (not shown).

As described above, the temperature detector 138 for ink temperature detection is integrally formed with the nozzle plate 130. Therefore, ink temperature can be more accurately detected, and thus, an active and accurate temperature control with respect to change of ink temperature is possible, thereby enhancing printing quality.

The nozzle plate 130 may also be formed with nozzle metal layers 136 surrounding the orifices of the nozzles 106. The nozzle metal layers 136 may be formed in a circular ring shape on a surface of the first silicon oxide layer 131 a around the orifices of the nozzles 106, as shown in FIG. 3. The nozzle metal layers 136 may be made of the same material as the heater 134 and the temperature detector 138. This case is advantageous because the nozzle metal layers 136 can be formed simultaneously with the heater 134 and the temperature detector 138. These nozzle metal layers 136 serve as etching masks for formation of the ink outlets 106b of the nozzles 106 in a nozzle plate manufacturing method as will be described later, which ensures accurate and easy formation of the ink outlets 106b.

The nozzle metal layers 136 may have a hydrophobic property according to a material. Further, to make the nozzles 106 more hydrophobic, as shown in FIG. 4, hydrophobic plating layers 137 may be formed on surfaces of the nozzle metal layers 136 using a good hydrophobic metal material, for example gold (Au). In this case, as will be described later, the nozzle metal layers 136 serve as seed layers when the hydrophobic plating layers 137 are formed by electroplating, which ensures easy formation of the hydrophobic plating layers 137.

In this way, when the nozzle metal layers 136 and the hydrophobic plating layers 137 are formed around the orifices of the nozzles 106, ink to be ejected through the nozzles 106 can form perfect ink droplets, thereby enhancing directionality of ink droplets and printing quality. Furthermore, since meniscus created in the nozzles 106 after ink ejection is rapidly stabilized, introduction of ambient air into the pressure chambers 104 and contamination about the nozzles 106 by ink can be prevented.

A second silicon oxide layer 132 is formed as a protection layer on a surface of the first silicon oxide layer 131a of a lower surface of the nozzle plate 130 and a surface of the heater 134 and the temperature detector 138. The second silicon oxide layer 132 is formed with contact holes **C** to expose the bonding pads 135 of the heater 134 and the bonding pads 139 of the temperature detector 138.

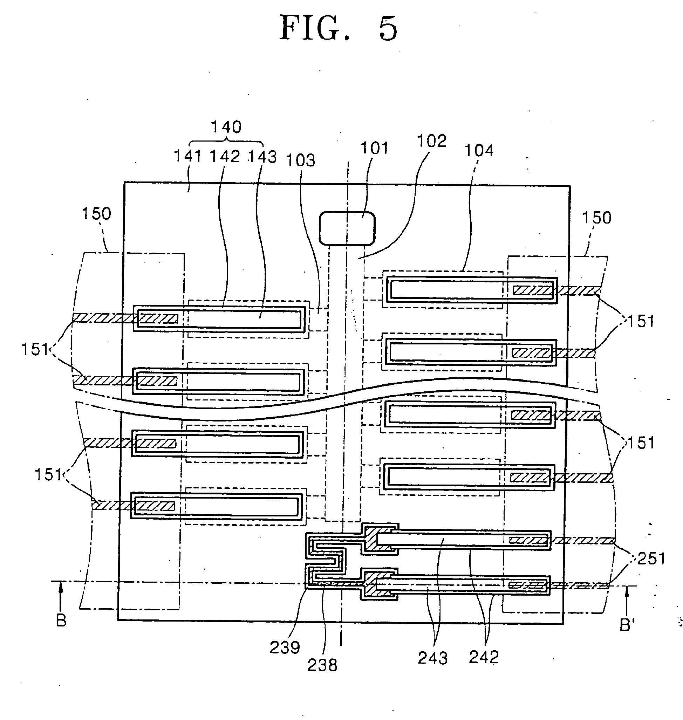

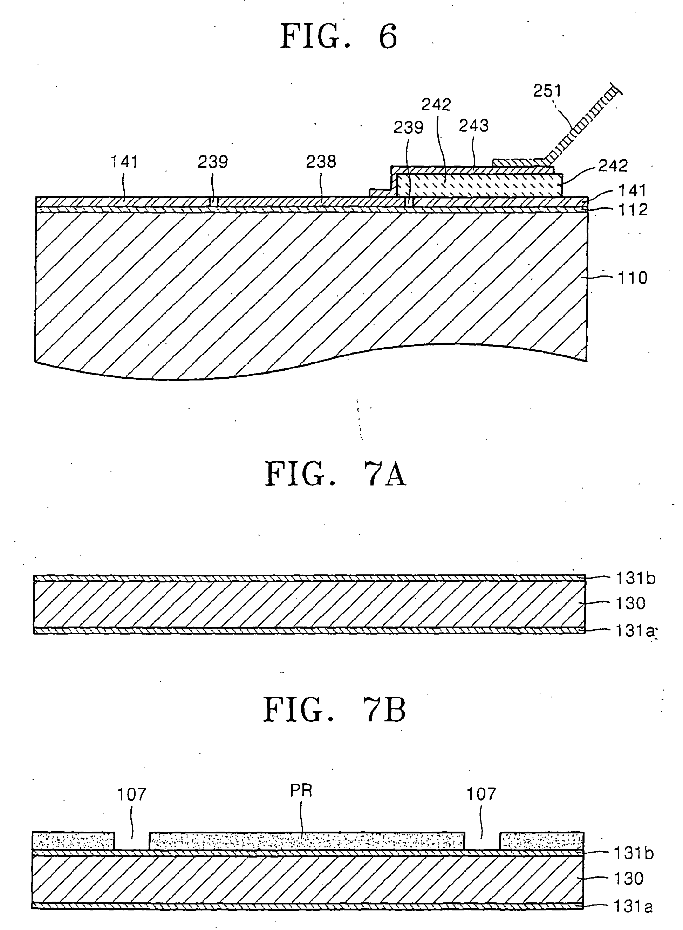

FIG. 5 is a top plan view of a piezoelectric inkjet printhead according to a second embodiment of the present invention and FIG. 6 is a partial vertical sectional view taken along line B-B' of FIG. 5. The inkjet printhead according to the second embodiment is the same as in the first embodiment except that a temperature detector is disposed at an upper side of a flow path plate. In this respect, descriptions about the same constitutional elements as in the first embodiment will be omitted or provided simply.

Referring to FIGS. 5 and 6, in a piezoelectric inkjet printhead according to the second embodiment, a temperature detector 238 for ink temperature detection is formed at an upper surface of a first flow path plate 110.

In detail, the temperature detector 238 is formed on an insulating layer 112 formed on an upper surface of the first flow path plate 110 and is insulated from a lower electrode 141 of a piezoelectric actuator 140. The temperature detector 238 may be made of Pt, like in the first embodiment. The temperature detector 238 may be formed on the same plane using the same material as for the lower electrode 141. The temperature detector 238 is defined by a surrounding trench 239 bored through the lower electrode 141 and is insulated from the lower electrode 141 by the trench 239.

Temperature detection signal lines 251 are electrically connected to the temperature detector 238. In detail, the temperature detection signal lines 251 may be arranged on a flexible printed circuit 150, together with driving signal lines 151 connected to upper electrodes 143 of the piezoelectric actuator 140. To easily connect the temperature detection signal lines 251 to the temperature detector 238, connection electrodes 243 for connecting the temperature detection signal lines 251 to the temperature detector 238 and dummy piezoelectric layers 242 for supporting the connection electrodes 243 are arranged on the lower electrode 141. The dummy piezoelectric layers 242 are disposed in parallel with piezoelectric layers 142 of the piezoelectric actuator 140 at one side of the first flow path plate 110. An end of each of the dummy piezoelectric layers 242 extends onto the temperature detector 238. The widths of the dummy piezoelectric layers 242 may be smaller than those of the piezoelectric layers 142 of the piezoelectric actuator 140. However, it is preferable that the heights of the dummy piezoelectric layers 242 are the same as those of the piezoelectric layers 142 since the connection electrodes 243 formed on the dummy piezoelectric layers 142 are easily bonded to the temperature detection signal lines 251. The connection electrodes 243 are formed on upper surfaces of the dummy piezoelectric layers 242 and an end of each of the connection electrodes 243 extends so that it exceeds a corresponding end of a corresponding one of the dummy piezoelectric layers 242 and contacts with an upper surface of the temperature detector 238. Therefore, an end of each of the connection electrodes 243 is electrically connected to the temperature detector 238.

As described above, according to the second embodiment of the present invention, since the temperature detector 238 for ink temperature detection is integrally formed with the piezoelectric actuator 140 of a printhead, ink temperature can be more accurately detected. Therefore, active and accurate temperature control with respect to change of ink temperature is possible, thereby enhancing printing quality.

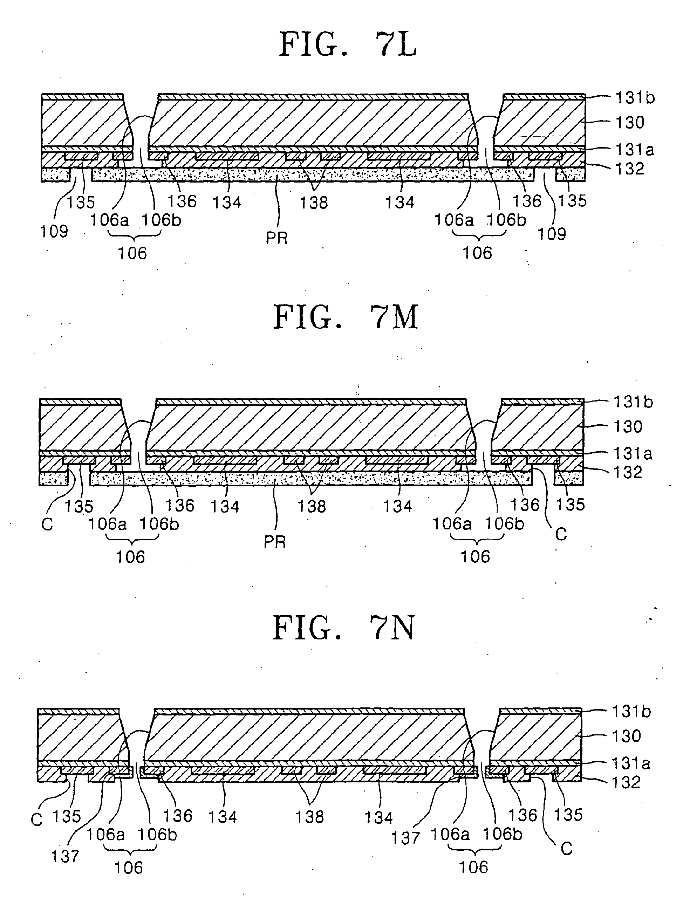

Hereinafter, a method of manufacturing a nozzle plate of an inkjet printhead according to the present invention will be described with reference to FIGS. 7A through 7N.

FIGS. 7A through 7N are sequential sectional views that illustrate a method of manufacturing a nozzle plate of a piezoelectric inkjet printhead according to the first embodiment shown in FIGS. 3 and 4.

Referring to FIG. 7A, a nozzle plate 130 is a monocrystalline silicon substrate and has a thickness of about 100-200µm, preferably 160µm. When the prepared silicon substrate 130 is wet- or dry-oxidized in an oxidizing furnace, first silicon oxide layers 131a and 131b are respectively formed as insulating layers on lower and upper surfaces of the silicon substrate 130, as shown in FIG. 7A. Meanwhile, the first silicon oxide layers 131a and 131b may also be formed by Chemical Vapor Deposition (CVD).

Next, referring to FIG. 7B, a photoresist PR is coated on the entire surface of the first silicon oxide layer 131b formed on the upper surface of the silicon substrate 130. Then, the photoresist PR is patterned to define openings 107 for ink guiding portions of nozzles. The patterning of the photoresist PR may be performed by known photolithography including exposure and development.

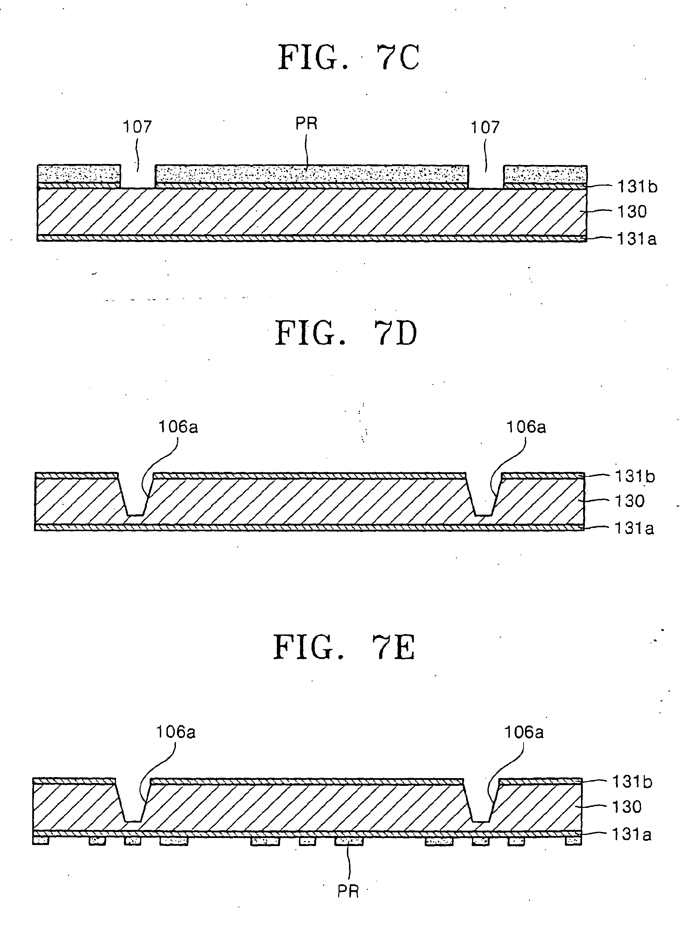

Next, referring to FIG. 7C, exposed portions of the first silicon oxide layer 131b through the openings 107 are wet-etched using the patterned photoresist PR as an etching mask to thereby partially expose an upper surface of the silicon substrate 130. Then, the photoresist PR is stripped. The exposed portions of the first silicon oxide layer 131b may also be removed by dry-etching such as Reactive Ion Etching (RIE), instead of wet-etching.

Next, referring to FIG. 7D, exposed portions of the silicon substrate 130 are etched to a predetermined depth using the first silicon oxide layer 131b as an etching mask to form ink guiding portions 106a. When the silicon substrate 130 is anisotropically wet-etched using TMAH (Tetramethyl Ammonium Hydroxide) or KOH (potassium hydroxide) as an etchant, the ink guiding portions 106a may be formed in a square pyramidal shape with slanted sidewalls.

Next, referring to FIG. 7E, a photoresist PR is coated on the entire surface of the first silicon oxide layer 131a formed on a lower surface of the silicon substrate 130. Then, the coated photoresist PR is patterned as shown in FIG. 3 to expose a portion of the first silicon oxide layer 131a intended for a heater 134. As described above, the photoresist PR can be patterned in a different manner according to the arrangement of the heater 134. Further, portions of the first silicon oxide layer 131a intended for a temperature detector 138 and nozzle metal layers 136 can also be exposed together with the portion intended for the heater 134.

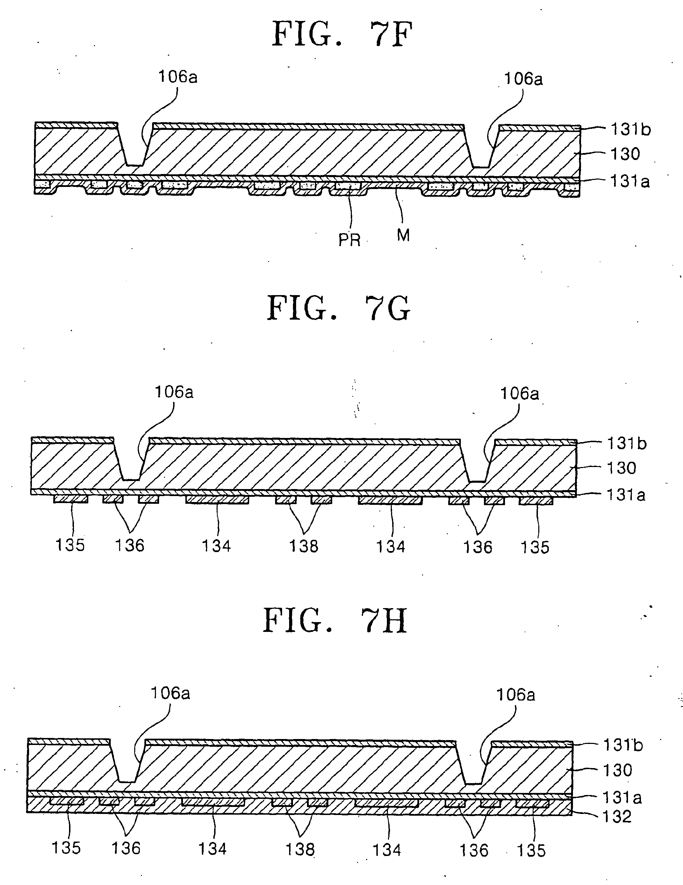

Next, referring to FIG. 7F, a metal material is sputtered on the patterned photoresist PR and the entire exposed portions of the first silicon oxide layer 131a to form a metal layer M. The metal material may be Pt as described above.

FIG. 7G illustrates the silicon substrate 130 with the heater 134, bonding pads 135, the temperature detector 138, and the nozzle metal layers 136 on the lower surface of the silicon substrate 130. In detail, when the photoresist PR shown in FIG. 7F is lift-off, the photoresist PR and portions of the metal layer M formed on the surface of the photoresist PR are removed and portions of the metal layer M formed on the exposed surface of the first silicon oxide layer 131a remain. The remaining portions of the metal layer M form the heater 134, the bonding pads 135, the temperature detector 138, and the nozzle metal layers 136.

Next, referring to FIG. 7H, a second silicon oxide layer 132 is deposited as a protection layer for protecting the heater 134, etc. on the entire lower surface of the resultant structure of FIG. 7G. At this time, the second silicon oxide layer 132 may be deposited by Plasma Enhanced Chemical Vapor Deposition (PECVD). However, if the heater 134, etc. are too thick, smoothness of the second silicon oxide layer 132 may be lowered, thereby affecting subsequent photoresist coating and patterning. In this case, the second silicon oxide layer 132 can be previously planarized by Chemical Mechanical Polishing (CMP).

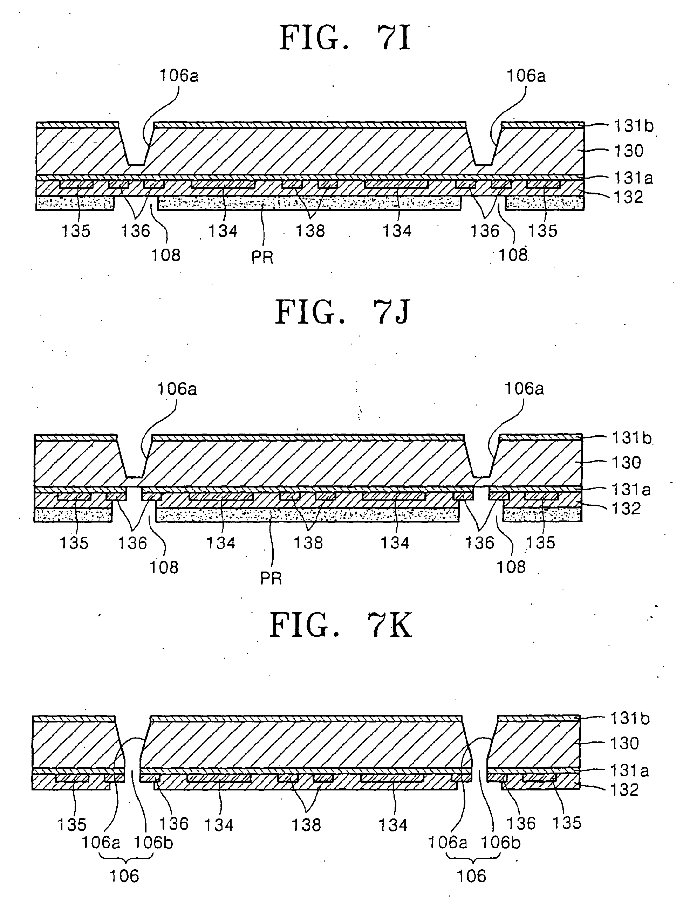

Next, referring to FIG. 7I, a photoresist PR is coated on the entire surface of the second silicon oxide layer 132 and patterned to form openings 108 corresponding to the ink guiding portions 106a.

Next, referring to FIG. 7J, the second silicon oxide layer 132 and the first silicon oxide layer 131a are sequentially dry-etched through the openings 108 using the photoresist PR as an etching mask and then the photoresist PR is stripped. As a result, the nozzle metal layers 136 and a lower surface of the silicon substrate 130 are exposed through the openings 108.

FIG. 7K illustrates the silicon substrate 130 with nozzles 106 composed of the ink guiding portions 106a and ink outlets 106b. In detail, the ink outlets 106b communicating with the ink guiding portions 106a are bored through the exposed portions of the silicon substrate 130 by etching. At this time, the silicon substrate 130 may be dry-etched by ICP (Inductively Coupled Plasma) using the nozzle metal layers 136 as etching masks.

Next, referring to FIG. 7L, a photoresist PR is coated on the entire lower surface of the resultant structure of FIG. 7K. At this time, a dry film photoresist PR is formed on the surface of the second silicon oxide layer 132 by a lamination process using heating and pressing. The dry film photoresist PR has the advantage of not entering into the nozzles 106. Then, the photoresist PR is patterned to form openings 109 corresponding to the bonding pads 135 of the heater 134.

Next, referring to FIG. 7M, portions of the second silicon oxide layer 132 exposed through the openings 109 are etched using the patterned photoresist PR as an etching mask, to form contact holes **C** through the bonding pads 135 of the heater 134 are exposed.

Meanwhile, in the steps shown in FIGS. 7L and 7M, contact holes intended for exposure of the bonding pads 139 of the temperature detector 138 shown in FIG. 3 may also be formed together with the contact holes **C**.

Next, stripping of the photoresist PR with acetone or the like completes the nozzle plate 130 through which the nozzles 106 are bored and including the heater 134, the bonding pads 135, the temperature detector 138, and the nozzle metal layers 136 on a lower surface of the nozzle plate 130.

As described above, to impart good hydrophobicity to the nozzles 106, a good hydrophobic metal material, for example Au may be coated on surfaces of the nozzle metal layers 136 to form hydrophobic plating layers 137. In detail, the hydrophobic plating layers 137 are formed by Au electroplating on surfaces of the previously formed nozzle metal layers 136 used as seed layers. At this time, even though the metal material, i.e., Au may also be coated on exposed surfaces of the bonding pads 135, the bonding pads 135 are not adversely affected due to conductivity of the metal material coated on the surfaces of the bonding pads 135.

In this way, according to the present invention, formation of.the hydrophobic plating layers 137 is possible even without deposition and patterning of a metal material for formation of a separate seed layer.

As apparent from the above description, according to an inkjet printhead of the present invention, a heater for heating ink is integrally formed with a nozzle plate, thereby simplifying the structure of the inkjet printhead and decreasing a manufacturing cost. Furthermore, since ink in the printhead is heated to a uniform temperature, ejection speed and volume of ink droplets through plural nozzles are maintained uniform, thereby enhancing printing quality.

Still furthermore, since a temperature detector for ink temperature detection is integrally formed with a nozzle plate or a piezoelectric actuator, ink temperature can be more accurately detected. Therefore, active and accurate temperature control with respect to change of ink temperature is possible, thereby enhancing printing quality.

In addition, since a heater metal layer and a nozzle metal layer surrounding a nozzle are formed together on a surface of a nozzle plate and a hydrophobic plating layer is formed on a surface of the nozzle metal layer, ink ejection performance such as directionality, volume, and ejection speed of ink droplets are enhanced, thereby enhancing printing quality.

Further, the nozzle metal layer surrounding the nozzle serves as an etching mask for formation of an ink outlet of the nozzle. This enables accurate and easy formation of the ink outlet and formation of the hydrophobic plating layer even without deposition and patterning of a metal material for formation of a separate seed layer.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A piezoelectric inkjet printhead for ejecting ink droplets onto a recording medium provided below the printhead, the printhead comprising:
a flow path plate (110, 120) formed with an ink flow path comprising a plurality of pressure chambers (104) filled with ink to be ejected;
a piezoelectric actuator (140) formed at an upper side of the flow path plate (110,120) for supplying a driving force for ink ejection to the pressure chambers (104);
a nozzle plate (130) bonded to the flow path plate (110, 120), a plurality of nozzles (106) for ink ejection from the pressure chambers (104) being bored through the nozzle plate (130); and
a heater (134) formed on a lower surface of the nozzle plate for heating ink in the ink flow path,
wherein the printhead is **characterized in that** it further comprises nozzle metal layers (136) formed around orifices of the nozzles (106) on the lower surface of the nozzle plate (130),
wherein the heater (134) and the nozzle metal layers (136) are formed on the same plane and made of the same metal material.

2. The piezoelectric inkjet printhead of claim 1, wherein an insulating layer (131a) is formed on a lower surface of the nozzle plate (130), the heater (134) and the nozzle metal layers (136) are formed in a predetermined pattern on a surface of the insulating layer (131 a), and a protection layer (132) for protecting the heater (134) and the nozzle metal layers (136) is formed on surfaces of the insulating layer (131a), the heater (134) and the nozzle metal layers (136).

3. The piezoelectric inkjet printhead of claim 2, wherein each of the insulating layer (131a) and the protection layer (132) is a silicon oxide layer.

4. The piezoelectric inkjet printhead of claim 2 or 3, wherein bonding pads (135) for bonding a power supply line are formed at both ends of the heater (134) and are exposed through contact holes (C) formed in the protection layer (132).

5. The piezoelectric inkjet printhead of any preceding claim, further comprising a temperature detector (138) for detecting a temperature of the ink in the ink flow path.

6. The piezoelectric inkjet printhead of claim 5, wherein the temperature detector (138) is made of a metal material having a variable resistance with respect to temperature.

7. The piezoelectric inkjet printhead of claim 5 or 6, wherein the temperature detector (138) is formed on a lower surface of the nozzle plate (130) together with the heater (134) and the nozzle metal layers (136).

8. The piezoelectric inkjet printhead of any of claims 5 to 7, wherein the temperature detector (138) is made of the same material as the heater (134) and the nozzle metal layers (136).

9. The piezoelectric inkjet printhead of claim 8, wherein the heater (134), the nozzle metal layers (136) and the temperature detector (138) are made of Pt.

10. The piezoelectric inkjet printhead of any of claims 5 to 9, wherein bonding pads (139) for bonding a temperature detection signal line are formed at both ends of the temperature detector (138).

11. The piezoelectric inkjet printhead of any preceding claim, wherein the nozzle metal layers (136) have a circular ring shape.

12. The piezoelectric inkjet printhead of any of claims 1 to 8, 10 and 11, wherein the heater (134) and the nozzle metal layers (136) are made of Pt.

13. The piezoelectric inkjet printhead of any preceding claim, wherein hydrophobic plating layers (137) are formed on surfaces of the nozzle metal layers (136).

14. The piezoelectric inkjet printhead of claim 13, wherein the hydrophobic plating layers (137) are made of Au.

15. A method of manufacturing a nozzle plate (130) of a piezoelectric inkjet printhead, the printhead having a plurality of nozzles (106) bored through the nozzle plate (130) for ejecting ink droplets onto a recording medium provided below the printhead, the method comprising:
a. preparing a silicon substrate (130);
b. forming ink guiding portions (106a) of the nozzles (106) by partially etching an upper surface of the silicon substrate (130);
c. coating a photoresist (PR) on a lower surface of the silicon substrate (130) followed by patterning;
d. forming a metal layer (M) on a lower surface of the silicon substrate (130) and a surface of the photoresist (PR);
e. lifting off the photoresist (PR) and removing the metal layer (M) formed on the surface of the photoresist (PR) to form a heater (134) for heating ink and nozzle metal layers (136) for surrounding orifices of the nozzles (106) from a residual portion of the metal layer (M);
f. forming a protection layer (132) for protecting the heater (134) and the nozzle metal layers (136) on a lower surface of the silicon substrate(130); and
g. forming openings (108) by partially etching the protection layer (132) and forming ink outlets (106b) communicating with the ink guiding portions (106a) by etching portions of the silicon substrate (130) exposed through the openings (108).

16. The method of claim 15, further comprising forming silicon oxide layers as insulating layers (131a, 131b) on lower and upper surfaces of the silicon substrate before step b.

17. The method of claim 15 or 16, wherein, in step d., the metal layer (M) is made of Pt.

18. The method of any of claims 15 to 17, wherein, in step e., the residual metal layer forms a temperature detector (138) for detecting ink temperature, in addition to the heater (134) and the nozzle metal layers (136).

19. The method of any of claims 15 to 18, wherein, in step g., the nozzle metal layers (136) are exposed through the openings (108) and are used as etching masks for etching the silicon substrate (130).

20. The method of any of claims 15 to 19, further comprising forming hydrophobic plating layers (137) on surfaces of the nozzle metal layers (136), after step g.

21. The method of claim 20, wherein the hydrophobic plating layers (137) are formed by electroplating using the nozzle metal layers (136) as seed layers.

22. The method of claim 20 or 21, wherein the hydrophobic plating layers (137) are made of Au.

23. The method of any of claims 15 to 22, wherein, in step g., a patterned dry film photoresist (PR) is used as an etching mask for etching the protection layer (132).

24. The method of any of claims 15 to 23, further comprising forming contact holes (C) intended for exposure of bonding pads (135) formed at both ends of the heater (134) by partially etching the protection layer (132), after step g.

## Patentansprüche

1. Piezoelektrischer Tintenstrahldruckkopf zum Ausstoßen von Tintentröpfchen auf ein Aufzeichnungsmedium, das unter dem Druckkopf vorgelegt ist, wobei der Druckkopf umfasst:
eine Strömungswegplatte (110, 120), die mit einem Tintenströmungsweg ausgebildet ist, umfassend eine Mehrzahl von Druckkammern (104), die mit auszustoßender Tinte gefüllt sind,
einen piezoelektrischen Aktuator (140), der an einer Oberseite der Strömungswegplatte (110, 120) ausgebildet ist, zum Beaufschlagen der Druckkammern (104) mit einer Antriebskraft zum Tintenausstoß,
eine Düsenplatte (130), die mit der Strömungswegplatte (110, 120) verbunden ist, wobei eine Mehrzahl von Düsen (106) zum Tintenausstoß aus den Druckkammern (104) durch die Düsenplatte (130) gebohrt sind, und
eine Erwärmungseinrichtung (134), die auf einer Unterseite der Düsenplatte ausgebildet ist, zum Erwärmen von Tinte im Tintenströmungsweg,
wobei der Druckkopf **dadurch gekennzeichnet ist, dass** er ferner Düsenmetallschichten (136) umfasst, die um Öffnungen der Düsen (106) an der Unterseite der Düsenplatte (130) ausgebildet sind,
wobei die Erwärmungseinrichtung (134) und die Düsenmetallschichten (136) auf der gleichen Ebene ausgebildet und aus dem gleichen metallischen Material gebildet sind.

2. Piezoelektrischer Tintenstrahldruckkopf nach Anspruch 1, wobei eine Isolierschicht (131a) an einer Unterseite der Düsenplatte (130) ausgebildet ist, die Erwärmungseinrichtung (134) und die Düsenmetallschichten (136) in einem vorgegebenen Muster auf einer Oberfläche der Isolierschicht (131 a) ausgebildet sind, und eine Schutzschicht (132) zum Schutz der Erwärmungseinrichtung (134) und der Düsenmetallschichten (136) auf Oberflächen der Isolierschicht (131 a), der Erwärmungseinrichtung (134) und der Düsenmetallschichten (136) ausgebildet ist.

3. Piezoelektrischer Tintenstrahldruckkopf nach Anspruch 2, wobei die Isolierschicht (131a) und die Schutzschicht (132) jeweils eine Siliciumoxidschicht ist.

4. Piezoelektrischer Tintenstrahldruckkopf nach Anspruch 2 oder 3, wobei Bondingpads (135) zum Verbinden einer Energiezufuhrleitung an beiden Enden der Erwärmungseinrichtung (134) ausgebildet und durch Kontaktlöcher (C), die in der Schutzschicht (132) ausgebildet sind, freigelegt sind.

5. Piezoelektrischer Tintenstrahldruckkopf nach einem der vorhergehenden Ansprüche, ferner umfassend einen Temperaturdetektor (138) zum Erfassen einer Temperatur der Tinte im Tintenströmungsweg.

6. Piezoelektrischer Tintenstrahldruckkopf nach Anspruch 5, wobei der Temperaturdetektor (138) aus einem metallischen Material gebildet ist, das einen mit der Temperatur variablen Widerstand aufweist.

7. Piezoelektrischer Tintenstrahldruckkopf nach Anspruch 5 oder 6, wobei der Temperaturdetektor (138) an einer Unterseite der Düsenplatte (130) zusammen mit der Erwärmungseinrichtung (134) und den Düsenmetallschichten (136) ausgebildet ist.

8. Piezoelektrischer Tintenstrahldruckkopf nach einem der Ansprüche 5 bis 7, wobei der Temperaturdetektor (138) aus dem gleichen Material wie die Erwärmungseinrichtung (134) und die Düsenmetallschichten (136) ausgebildet ist.

9. Piezoelektrischer Tintenstrahldruckkopf nach Anspruch 8, wobei die Erwärmungseinrichtung (134), die Düsenmetallschichten (136) und der Temperaturdetektor (138) aus Pt gebildet sind.

10. Piezoelektrischer Tintenstrahldruckkopf nach einem der Ansprüche 5 bis 9, wobei Bondingpads (139) zum Verbinden einer Temperaturerfassungssignalleitung an beiden Enden des Temperaturdetektors (138) ausgebildet sind.

11. Piezoelektrischer Tintenstrahldruckkopf nach einem der vorhergehenden Ansprüche, wobei die Düsenmetallschichten (136) eine Ringform aufweisen.

12. Piezoelektrischer Tintenstrahldruckkopf nach einem der Ansprüche 1 bis 8, 10 und 11, wobei die Erwärmungseinrichtung (134) und die Düsenmetallschichten (136) aus Pt gebildet sind.

13. Piezoelektrischer Tintenstrahldruckkopf nach einem der vorhergehenden Ansprüche, wobei hydrophobe Plattierungsschichten (137) auf Oberflächen der Düsenmetallschichten (136) ausgebildet sind.

14. Piezoelektrischer Tintenstrahldruckkopf nach Anspruch 13, wobei die hydrophoben Plattierungsschichten (137) aus Au gebildet sind.

15. Verfahren zur Herstellung einer Düsenplatte (130) eines piezoelektrischen Tintenstrahldruckkopfs, wobei der Druckkopf eine Mehrzahl von Düsen (106) aufweist, die durch die Düsenplatte (130) gebohrt sind, um Tintentröpfchen auf ein Aufzeichnungsmedium auszustoßen, das unter dem Druckkopf vorgelegt ist, wobei das Verfahren umfasst:
a. Vorbereiten eines Siliciumsubstrats (130),
b. Ausbilden von Tintenführungsbereichen (106a) in den Düsen (106) durch partielles Ätzen einer Oberseite des Siliciumsubstrats (130),
c. Auftragen eines Photoresist (PR) auf eine Unterseite des Siliciumsubstrats (130) gefolgt von einem Strukturieren,
d. Ausbilden einer Metallschicht (M) auf einer Unterseite des Siliciumsubstrats (130) und einer Oberfläche des Photoresist (PR),
e. Abziehen des Photoresist (PR) und Entfernen der Metallschicht (M), die auf der Oberfläche des Photoresist (PR) ausgebildet ist, zum Ausbilden einer Erwärmungseinrichtung (134) zum Erwärmen von Tinte und Ausbilden von Düsenmetallschichten (136), die Öffnungen der Düsen (106) umgeben, aus einem Restbereich der Metallschicht (M),
f. Ausbilden einer Schutzschicht (132) zum Schutz der Erwärmungseinrichtung (134) und der Düsenmetallschichten (136) auf einer Unterseite des Siliciumsubstrats (130), und
g. Ausbilden von Öffnungen (108) durch partielles Ätzen der Schutzschicht (132) und Ausbilden von Tintenauslässen (106b), die mit den Tintenführungsbereichen (106a) kommunizieren, durch Ätzen von Bereichen des Siliciumsubstrats (130), die durch die Öffnungen (108) freigelegt sind.

16. Verfahren nach Anspruch 15, ferner umfassend, vor Schritt b.: Ausbilden von Siliciumoxidschichten als Isolierschichten (131 a, 131b) auf Unter- und Oberseite des Siliciumsubstrats.

17. Verfahren nach Anspruch 15 oder 16, wobei in Schritt d. die Metallschicht (M) aus Pt gebildet wird.

18. Verfahren nach einem der Ansprüche 15 bis 17, wobei in Schritt e. die Restmetallschicht zusätzlich zur Erwärmungseinrichtung (134) und den Düsenmetallschichten (136) einen Temperaturdetektor (138) zum Erfassen der Tintentemperatur bildet.

19. Verfahren nach einem der Ansprüche 15 bis 18, wobei in Schritt g. die Düsenmetallschichten (136) durch die Öffnungen (108) freigelegt werden und als Ätzmasken zum Ätzen des Siliciumsubstrats (130) verwendet werden.

20. Verfahren nach einem der Ansprüche 15 bis 19, ferner umfassend, nach Schritt g.: Ausbilden hydrophober Plattierungsschichten (137) auf Oberflächen der Düsenmetallschichten (136).

21. Verfahren nach Anspruch 20, wobei die hydrophoben Plattierungsschichten (137) durch Elektroplattieren unter Verwendung der Düsenmetallschichten (136) als Keimschichten gebildet werden.

22. Verfahren nach Anspruch 20 oder 21, wobei die hydrophoben Plattierungsschichten (137) aus Au gebildet werden.

23. Verfahren nach einem der Ansprüche 15 bis 22, wobei in Schritt g. ein strukturierter Trockenfilmphotoresist (PR) als Ätzmaske zum Ätzen der Schutzschicht (132) verwendet wird.

24. Verfahren nach einem der Ansprüche 15 bis 23, ferner umfassend, nach Schritt g.: Ausbilden von Kontaktlöchern (C), die zum Freilegen von an beiden Enden der Erwärmungseinrichtung (134) ausgebildeten Bondingpads (135) vorgesehen sind, durch partielles Ätzen der Schutzschicht (132).

## Revendications

1. Tête d'impression à jet d'encre piézoélectrique destinée à éjecter des gouttelettes d'encre sur un support d'enregistrement placé sous la tête d'impression, la tête d'impression comprenant :
une plaque de passage de flux (110, 120) formée avec un passage de flux d'encre comprenant une pluralité de chambres de pression (104) remplies d'encre à éjecter ;
un actionneur piézoélectrique (140) formé sur un côté supérieur de la plaque de passage de flux (110,120) destiné à alimenter une force d'entraînement pour l'éjection de l'encre aux chambres de pression (104) ;
une plaque des buses (130) reliée à la plaque de passage de flux (110, 120), une pluralité de buses (106) destinées à l'éjection d'encre depuis les chambres de pression (104) étant percées à travers la plaque des buses (130) ; et
un système de chauffage (134) formé sur une surface inférieure de la plaque des buses destiné à chauffer l'encre dans le passage de flux d'encre,
dans laquelle la tête d'impression est **caractérisée en ce qu'**elle comprend en outre des couches métalliques de buses (136) formées autour des orifices des buses (106) sur la surface inférieure de la plaque des buses (130),
dans laquelle le système de chauffage (134) et les couches métalliques de buses (136) sont formés sur le même plan et composés du même matériau métallique.

2. Tête d'impression à jet d'encre piézoélectrique selon la revendication 1, dans laquelle une couche isolante (131a) est formée sur une surface inférieure de la plaque des buses (130), le système de chauffage (134) et les couches métalliques de buses (136) sont formés selon un motif prédéterminé sur une surface de la couche isolante (131a), et une couche de protection (132), destinée à protéger le système de chauffage (134) et les couches métalliques de buses (136), est formée sur des surfaces de la couche isolante (131 a), du système de chauffage (134) et des couches métalliques de buses (136).

3. Tête d'impression à jet d'encre piézoélectrique selon la revendication 2, dans laquelle la couche isolante (131a) et la couche de protection (132) sont chacune une couche d'oxyde de silicium.

4. Tête d'impression à jet d'encre piézoélectrique selon la revendication 2 ou 3, dans laquelle des plots de connexion (135) destinés à relier une ligne d'alimentation électrique sont formés aux deux extrémités du système de chauffage (134) et sont exposés à travers des orifices de contact (C) formés dans la couche de protection (132).

5. Tête d'impression à jet d'encre piézoélectrique selon l'une quelconque des revendications précédentes, comprenant en outre un détecteur de température (138) destiné à détecter une température de l'encre dans le passage de flux d'encre.

6. Tête d'impression à jet d'encre piézoélectrique selon la revendication 5, dans laquelle le détecteur de température (138) est composé d'un matériau métallique ayant une résistance variable en fonction de la température.

7. Tête d'impression à jet d'encre piézoélectrique selon la revendication 5 ou 6, dans laquelle le détecteur de température (138) est formé sur une surface inférieure de la plaque des buses (130) avec le système de chauffage (134) et les couches métalliques de buses (136).

8. Tête d'impression à jet d'encre piézoélectrique selon l'une quelconque des revendications 5 à 7, dans laquelle le détecteur de température (138) est composé du même matériau que le système de chauffage (134) et les couches métalliques de buses (136).

9. Tête d'impression à jet d'encre piézoélectrique selon la revendication 8, dans laquelle le système de chauffage (134), les couches métalliques de buses (136) et le détecteur de température (138) sont composés de Pt.

10. Tête d'impression à jet d'encre piézoélectrique selon l'une quelconque des revendications 5 à 9, dans laquelle des plots de connexion (139) destinés à relier une ligne de signal de détection de température sont formés aux deux extrémités du détecteur de température (138).

11. Tête d'impression à jet d'encre piézoélectrique selon l'une quelconque des revendications précédentes, dans laquelle les couches métalliques de buses (136) ont une forme d'anneau circulaire.

12. Tête d'impression à jet d'encre piézoélectrique selon l'une quelconque des revendications 1 à 8, 10 et 11, dans laquelle le système de chauffage (134) et les couches métalliques de buses (136) sont composés de Pt.

13. Tête d'impression à jet d'encre piézoélectrique selon l'une quelconque des revendications précédentes, dans laquelle des couches de revêtement hydrophobe (137) sont formées sur des surfaces des couches métalliques de buses (136).

14. Tête d'impression à jet d'encre piézoélectrique selon la revendication 13, dans laquelle les couches de revêtement hydrophobe (137) sont composées d'Au.

15. Procédé de fabrication d'une plaque des buses (130) d'une tête d'impression à jet d'encre piézoélectrique, la tête d'impression possédant une pluralité de buses (106) percées à travers la plaque des buses (130) destinées à éjecter des gouttelettes d'encre sur un support d'enregistrement placé sous la tête d'impression, le procédé comprenant les étapes consistant à :
a.préparer un substrat de silicium (130) ;
b. former des parties de guidage d'encre (106a) des buses (106) en attaquant partiellement une surface supérieure du substrat de silicium (130) ;
c. appliquer une résine photosensible (PR) sur une surface inférieure du substrat de silicium (130) puis réaliser un modelage ;
d. former une couche métallique (M) sur une surface inférieure du substrat de silicium (130) et une surface de la résine photosensible (PR) ;
e. soulever la résine photosensible (PR) et retirer la couche métallique (M) formée sur la surface de la résine photosensible (PR) pour former un système de chauffage (134) destiné à chauffer l'encre et des couches métalliques de buses (136) destinées à entourer les orifices des buses (106) à partir d'une partie résiduelle de la couche métallique (M) ;
f. former une couche de protection (132) destinée à protéger le système de chauffage (134) et les couches métalliques de buses (136) sur une surface inférieure du substrat de silicium (130) ; et
g. former des ouvertures (108) en attaquant partiellement la couche de protection (132) et en formant des sorties d'encre (106b) qui communiquent avec les parties de guidage d'encre (106a) en attaquant des parties du substrat de silicium (130) exposées par le biais des ouvertures (108).

16. Procédé selon la revendication 15, comprenant en outre la formation de couches d'oxyde de silicium en guise de couches isolantes (131a, 131b) sur les surfaces inférieure et supérieure du substrat de silicium avant l'étape b.

17. Procédé selon la revendication 15 ou 16, dans lequel, lors de l'étape d., la couche métallique (M) est composée de Pt.

18. Procédé selon l'une quelconque des revendications 15 à 17, dans lequel, lors de l'étape e., la couche métallique résiduelle forme un détecteur de température (138) destiné à détecter la température de l'encre, en plus du système de chauffage (134) et des couches métalliques de buses (136).

19. Procédé selon l'une quelconque des revendications 15 à 18, dans lequel, lors de l'étape g., les couches métalliques de buses (136) sont exposées par le biais des ouvertures (108) et sont utilisées en guise de masques d'attaque pour attaquer le substrat de silicium (130).

20. Procédé selon l'une quelconque des revendications 15 à 19, comprenant en outre la formation de couches de revêtement hydrophobe (137) sur des surfaces des couches métalliques de buses (136), après l'étape g.

21. Procédé selon la revendication 20, dans lequel les couches de revêtement hydrophobe (137) sont formées par électroplastie en utilisant les couches métalliques de buses (136) en guise de couches d'amorce.

22. Procédé selon la revendication 20 ou 21, dans lequel les couches de revêtement hydrophobe (137) sont composées d'Au.

23. Procédé selon l'une quelconque des revendications 15 à 22, dans lequel, lors de l'étape g., un film sec à motifs de résine photosensible (PR) est utilisé en guise de masque d'attaque pour attaquer la couche de protection (132).

24. Procédé selon l'une quelconque des revendications 15 à 23, comprenant en outre la formation d'orifices de contact (C) destinés à l'exposition de plots de connexion (135) formés aux deux extrémités du système de chauffage (134) en attaquant partiellement la couche de protection (132), après l'étape g.
